(19) Europäisches Patentamt
European Patent Office
Office européen des brevets

(11) Veröffentlichungsnummer: **0 068 346**
**B1**

# (12) EUROPÄISCHE PATENTSCHRIFT

(45) Veröffentlichungstag der Patentschrift: **31.10.84**

(51) Int. Cl.³: **G 03 C 1/56,** G 03 F 7/08, G 03 F 7/26

(21) Anmeldenummer: **82105342.8**

(22) Anmeldetag: **18.06.82**

(54) **Lichtempfindliches Gemisch auf Basis von o-Naphthochinondiaziden und daraus hergestelltes lichtempfindliches Kopiermaterial.**

(30) Priorität: **25.06.81 DE 3124936**

(43) Veröffentlichungstag der Anmeldung: **05.01.83 Patentblatt 83/1**

(45) Bekanntmachung des Hinweises auf die Patenterteilung: **31.10.84 Patentblatt 84/44**

(84) Benannte Vertragsstaaten: **AT BE CH DE FR GB IT LI NL SE**

(56) Entgegenhaltungen: **DE - A - 2 828 037**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr. Dipl.-Chem., Leubnizstrasse 18b, D-6200 Wiesbaden (DE)**

EP 0 068 346 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die Erfindung betrifft ein positiv arbeitendes lichtempfindliches Gemisch, das als lichtempfindliche Verbindung einen Naphthochinon-(1,2)-diazid-(2)-sulfonsäureester eines Bis-hydroxyphenyl-alkans enthält und das insbesondere zur Herstellung von Flachdruckplatten bestimmt ist.

Lichtempfindliche Verbindungen der angegebenen Gattung sind aus der DE-PS 872 154 bekannt. Es handelt sich hierbei um mit Naphthochinondiazidsulfonsäure verestertes 2,2-Bis-(4-hydroxy-phenyl)-propan oder Bis-(4-hydroxyphenyl)methan. Diese Verbindung weisen eine relativ hohe Lichtempfindlichkeit auf und ergeben gute Druckauflagen, sie haben jedoch den Nachteil einer für manche Zwecke zu geringen Löslichkeit in den üblicherweise zur Beschichtung von Druckplatten verwendeten organischen Lösungsmitteln, wie Glykolpartialethern oder Carbonsäurealkylestern wie Butylacetat. Sie ergeben ferner in Kombination mit den bevorzugten, wasserunlöslichen, in wäßrig-alkalischen Lösungsmitteln löslichen Bindemitteln, z. B. Novolaken, Schichten, die in unbelichtetem Zustand gegenüber den gebräuchlichen alkalischen Entwicklerlösungen nicht genügend resistent sind. Diese Schichten werden auch während des Drucks in Offsetdruckmaschinen bei Verwendung von Alkohol enthaltenden Feuchtwässern in gewissem Maße angegriffen.

Aus der DE-OS 2 828 037 sind Gemische bekannt, die Naphthochinondiazidsulfonsäureester von bestimmten Bisphenolderivaten enthalten, in denen zwei Benzolringe über eine aliphatisch substituierte Methylenbrücke verbunden sind. Diese Verbindungen haben eine hohe Löslichkeit in organischen Lösungsmitteln. Ihre Resistenz gegenüber alkalischen Entwicklerlösungen und Alkohol enthaltenden Feuchtwässern ist jedoch nicht optimal.

Aufgabe der Erfindung war es, ein lichtempfindliches, positiv arbeitendes Gemisch mit einem neuen Naphthochinon-(1,2)-diazid-(2)-sulfonsäureester als lichtempfindliche Verbindung vorzuschlagen, das in seinen druck- und kopiertechnischen Eigenschaften mit den besten bisher bekannten Gemischen dieser Art mindestens vergleichbar ist, das aber eine höhere Resistenz gegenüber wäßrigalkalischen Entwicklerlösungen und den beim Offsetdruck verwendeten Alkohol enthaltenden Feuchtwässern, eine harte Gradation, eine hohe Löslichkeit in organischen Lösungsmitteln und gute Oleophilie aufweist und sich in einfacher Weise in chemisch einheitlicher Form herstellen läßt.

Gegenstand der Erfindung ist ein lichtempfindliches Gemisch, das als lichtempfindliche Verbindung einen Naphthochinon-(1,2)-diazid-(2)-4- oder -5-sulfonsäureester eines Bis-hydroxyphenyl-alkans enthält.

Das erfindungsgemäße Gemisch ist dadurch gekennzeichnet, daß der Naphthochinondiazidsulfonsäureester der allgemeinen Formel I

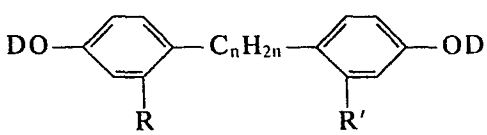

(I)

entspricht, worin

| | |
|---|---|
| D | der Naphthochinon-(1,2)-diazid-(2)-5-sulfonyl- oder -4-sulfonyl-, bevorzugt der -5-sulfonylrest ist, |
| R und R' | Wasserstoffatome, Alkylgruppen mit 1—4 Kohlenstoffatomen oder Reste der Formel DO sind und |
| n | eine Zahl von 6 bis 18, bevorzugt von 8 bis 14, |

bedeutet.

Bevorzugt ist mindestens einer der Reste R und $R^1$ eine DO-Gruppe, und allgemein sind R und R' vorzugsweise gleich.

Die in dem erfindungsgemäßen Gemisch enthaltenen Chinondiazide sind neu. Ihre Herstellung erfolgt in Analogie zu bekannten Verfahren durch Veresterung der phenolischen OH-Gruppen der zugrundeliegenden mehrwertigen Phenole mit o-Chinondiazidsulfonsäuren oder deren reaktionsfähigen Derivaten, z. B. den Sulfonsäurechloriden.

Die entsprechenden Vorprodukte, z. B. die Polymethylenbisphenole, werden in der Weise hergestellt, daß langkettige aliphatische Diole mit 2 Mol Phenol in Gegenwart von wasserabspaltenden Verbindungen, wie Bortrifluorid oder Zinkchlorid, 3 bis 7 Stunden auf 120 bis 170°C erhitzt werden. Derartige Verbindungen sind beschrieben in der US-PS 2 321 620 und in J. Am. Chem. Soc. 62 (1940), Seite 413. Auch durch Reduktion der beiden Ketogruppen von Polymethylendiketophenolen nach Clemmensen, die durch Umsetzung von höheren Paraffindicarbonsäuren mit Phenolen hergestellt werden (Chem. Ber. 74 [1941], Seite 1772) lassen sich die entsprechenden Alkylenbisphenole vorteilhaft gewinnen. Die Herstellung von 1,1-Bis-(4-hydroxyphenyl)-alkanen erfolgt durch Kondensation von 2 Mol Phenol mit 1 Mol eines höheren aliphatischen Aldehyds in Gegenwart von Salzsäure. Entsprechende Verbindungen sind beschrieben in J. Am. Chem. Soc. 54 (1932), Seite 4325.

Die Konzentration der neuen Naphthochinondiazidsulfonsäureester in der lichtempfindlichen Schicht kann in relativ weiten Grenzen schwanken. Im allgemeinen liegt der Anteil bei 3 bis 50, vorzugsweise zwischen 7 und 25%, bezogen auf das Gewicht des Feststoffanteils des lichtempfindlichen Gemischs.

Die erfindungsgemäßen lichtempfindlichen Gemische enthalten bevorzugt ferner ein polymeres, wasserunlösliches harzartiges Bindemittel, das sich in den für das erfindungsgemäße Gemisch verwendeten Lösungsmitteln löst und in wäßriger Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemäßen Gemischen mit den neuen Naphthochinondiazidsulfonsäureestern als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Als weitere alkalilösliche bzw. in Alkali quellbare Bindemittel sind natürliche Harze, wie Schellack und Kolophonium, und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein; bevorzugt werden Anteile am Gesamtfeststoff zwischen 95 und 50, besonders bevorzugt 90—65 Gew.-%. Zusätzlich können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrroldidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether, werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonate oder mit hydrolysiertem Tetraethylorthosilikat, vorbehandelt sein kann, außerdem Mehrmetallplatten z. B. aus Al/Cu/Cr oder aus Messing/Chrom. Für die Herstellung von Hochdruckplatten können die erfindungsgemäßen Gemische auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich die erfindungsgemäßen Gemische durch ihre gute Haftung und Ätzfestigkeit auf Kupfer- und Nickeloberflächen. Ebenso lassen sich die erfindungsgemäßen Gemische als Photoresists in der Leiterplattenfertigung und beim Formteilätzen verwenden. Für weitere Anwendungen kommen auch andere Träger wie Holz, Papier, Keramik, Textil und andere Metalle in Betracht.

Bevorzugte Träger für dicke Schichten über 10 µm sind Kunststoff-Folien, die dann als temporäre Träger für Transferschichten dienen. Dafür und für Farbprüffolien werden Polyesterfolien, z. B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Schließlich kann die Beschichtung von z. B. Leiterplatten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Lasern stellt eine Möglichkeit zur Bebilderung dar.

Die zum Entwickeln verwendeten wäßrig-alkalischen Lösungen abgestufter Alkalität, vorzugsweise mit einem pH im Bereich von 10—14, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung von Druckformen, d. h. insbesondere Offset-, autotypischen Tiefdruck- und Siebdruckformen, in Kopierlacken und sogenannten Trockenresists.

Die unter Verwendung der neuen Verbindungen hergestellten Druckplatten besitzen eine hohe praktische Lichtempfindlichkeit, sowie eine verbesserte Resistenz gegenüber alkalischen Entwicklern. Die

bevorzugten Verbindungen selbst zeichnen sich durch eine sehr gute Löslichkeit in den üblichen Lösungsmitteln, durch eine starke Oleophilie und Alkoholresistenz sowie durch eine gute Verträglichkeit mit den übrigen Bestandteilen der Kopierschicht aus.

Die Erfindung wird an Hand der folgenden Beispiele näher erläutert, in denen Gewichtsteile (Gt) und Volumenteile (Vt) im Verhältnis von g zu ccm stehen. Prozente sind, wenn nichts anderes angegeben ist, Gewichtsprozente.

Beispiel 1

Mit einer Lösung von

| | |
|---|---|
| 1,10 Gt | des Veresterungsproduktes aus 1 Mol 1,10-Bis-(4-hydroxy-phenyl)-decan und 2 Mol Naphthochinon-(1,2)-diazid-(2)-5-sulfonsäurechlorid, |
| 6,10 Gt | eines Kresol-Formaldehyd-Novolaks mit einem Erweichungspunkt von 105—120°C nach DIN 53 181, |
| 0,12 Gt | 4-(p-Tolylmercapto)-2,5-diethoxy-benzoldiazoniumhexafluorophosphat und |
| 0,06 Gt | Kristallviolett in |
| 40 Gt | Ethylenglykolmonomethylether und |
| 50 Gt | Tetrahydrofuran |

wurde eine elektrolytisch aufgerauhte und anodisierte Aluminiumplatte mit einem Oxidgewicht von 3,0 $g/m^2$ beschichtet. Der anodisierte Aluminium-Träger war vor dem Aufbringen der lichtempfindlichen Kopierschicht mit einer wäßrigen Lösung von Polyvinylphosphonsäure behandelt worden, wie es in der DE-PS 1 621 478 beschrieben ist.

Das so hergestellte vorsensibilisierte Material mit einem Schichtgewicht der lichtempfindlichen Schicht von 2,00 $g/m^2$ wurde unter einer transparenten Positiv-Vorlage bildmäßig belichtet und anschließend mit der folgenden Lösung entwickelt:

| | |
|---|---|
| 5,3 Gt | Natriummetasilikat × 9 Wasser |
| 3,4 Gt | Trinatriumphosphat × 12 Wasser |
| 0,3 Gt | Natriumdihydrogenphosphat (wasserfrei) in |
| 91,0 Gt | Wasser. |

Durch die Entwicklung wurden die von Licht getroffenen Anteile der Kopierschicht entfernt, und es blieben die unbelichteten Bildstellen auf dem Schichtträger zurück. Von der so hergestellten Druckform wurden in einer Offsetmaschine etwa 200 000 einwandfreie Drucke hergestellt. Die Druckschablone zeichnete sich durch eine ausgezeichnete Oleophilie, Alkoholresistenz und Haftung auf dem Träger aus.

In den folgenden Beispielen werden weitere Beschichtungslösungen angegeben, mit denen ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

| | |
|---|---|
| 1,00 Gt | des Veresterungsproduktes aus 1 Mol 1,10-Bis-(2,4-dihydroxy-phenyl)-decan und 4 Mol Naphthochinon-(1,2)-diazid-(2)-5-sulfonsäurechlorid |
| 5,70 Gt | des in Beispiel 1 angegebenen Novolaks |
| 0,12 Gt | Naphthochinon-(1,2)-diazid-(2)-4-sulfonsäurechlorid, und |
| 0,07 Gt | Kristallviolett in |
| 30 Gt | Ethylenglykolmonomethylether, |
| 40 Gt | Tetrahydrofuran und |
| 10 Gt | Butylacetat |

wurde eine elektrolytisch aufgerauhte und anodisierte Aluminiumplatte beschichtet, die mit einer wäßrigen Lösung von Polyvinylphophonsäure nachbehandelt worden war.

Beispiel 3

Mit einer Lösung von

| | |
|---|---|
| 1,20 Gt | des Veresterungsproduktes aus 1 Mol 1,1-Bis-(4-hydroxy-2-methyl-phenyl)-dodecan und 2 Mol Naphthochinon-(1,2)-diazid-(2)-5-sulfonsäurechlorid, |

| | |
|---|---|
| 6,20 Gt | des in Beispiel 1 angegebenen Novolaks, |
| 0,13 Gt | 4-(p-Tolylmercapto)-2,5-diethoxy-benzol-diazoniumhexafluorophosphat und |
| 0,07 Gt | Kristallviolett in |
| 40 Gt | Ethylenglykolmonomethylether und |
| 50 Gt | Tetrahydrofuran |

wurde eine elektrolytisch aufgerauhte und anodisierte Aluminiumplatte beschichtet.

Beispiel 4

Mit einer Lösung von

| | |
|---|---|
| 1,10 Gt | des Veresterungsproduktes aus 1 Mol 1,12-Bis-(4-hydroxy-2-methyl-phenyl)-dodecan und 2 Mol Naphthochinon-(1,2)-diazid-(2)-5-sulfonsäurechlorid, |
| 6,10 Gt | des in Beispiel 1 angegebenen Novolaks |
| 0,08 Gt | 2,3,4-Trihydroxy-benzophenon, |
| 0,20 Gt | eines Polyvinylbutyrals mit 69—71%Vinylbutyral-, 24—27% Vinylalkohol- und 1% Vinylacetateinheiten und |
| 0,07 Gt | Kristallviolett in |
| 30 Gt | Ethylenglykolmonomethylether, |
| 40 Gt | Tetrahydrofuran und |
| 10 Gt | Butylacetat |

wurde eine elektrolytisch aufgerauhte und anodisierte Aluminiumplatte beschichtet, die mit einer wäßrigen Lösung von Polyvinylphosphonsäure nachbehandelt worden war.

## Patentansprüche

1. Lichtempfindliches Gemisch, das als lichtempfindliche Verbindung einen Naphthochinon-(1,2)-diazid-(2)-4- oder -5-sulfonsäureester eines Bis-hydroxyphenyl-alkans enthält, dadurch gekennzeichnet, daß der Naphthochinondiazidsulfonsäureester der allgemeinen Formel I

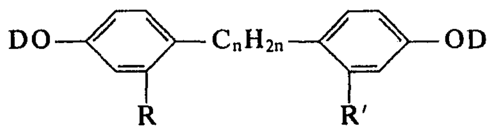

(I)

entspricht, worin

| | |
|---|---|
| D | der Naphthochinon-(1,2)-diazid-(2)-5-sulfonyl- oder -4-sulfonylrest ist, |
| R und R' | Wasserstoffatome, Alkylgruppen mit 1—4 Kohlenstoffatomen oder Reste der Formel DO sind und |
| n | eine Zahl von 6 bis 18 |

bedeutet.

2. Lichtempfindliches Gemisch nach Anspruch 1, dadurch gekennzeichnet, daß es zusätzlich ein wasserunlösliches, in wäßrig-alkalischen Lösungen lösliches oder mindestens Bindemittel enthält.

3. Lichtempfindliches Gemisch nach Anspruch 1, dadurch gekennzeichnet, daß es 3 bis 50 Gew.-% Naphthochinodiazidsulfonsäureester, bezogen auf seinen Gehalt an nichtflüchtigen Bestandteilen, enthält.

4. Lichtempfindliches Gemisch nach Anspruch 1, dadurch gekennzeichnet, daß es eine Verbindung der Formel I enthält, in der mindestens einer der Reste R und R' ein DO-Rest ist.

5. Lichtempfindliches Gemisch nach Anspruch 1, dadurch gekennzeichnet, daß es eine Verbindung der Formel I enthält, in der n eine Zahl von 8 bis 14 ist.

6. Lichtempfindliches Kopiermaterial aus einem Schichtträger und einer lichtempfindlichen Schicht, die einen Naphthochinon-(1,2)-diazid-(2)-sulfonsäureester eines Bis-hydroxyphenyl-alkans enthält, dadurch gekennzeichnet, daß der Naphthochinondiazidsulfonsäureester der allgemeinen Formel I

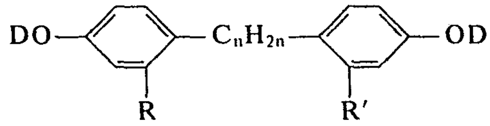

(I)

entspricht, worin

| | |
|---|---|
| D | der Naphthochinon-(1,2)-diazid-(2)-5-sulfonyl- oder -4-sulfonylrest ist, |
| R und R′ | Wasserstoffatome, Alkylgruppen mit 1–4 Kohlenstoffatomen oder Reste der Formel DO sind und |
| n | eine Zahl von 6 bis 18 |

bedeutet.

7. Lichtempfindliches Kopiermaterial nach Anspruch 6, dadurch gekennzeichnet, daß der Schichtträger aus Aluminium besteht.

## Claims

1. A light-sensitive mixture which contains, as the light-sensitive compound, a 1,2-naphthoquinone-2-diazide-4-sulfonic or 1,2-naphthoquinone-2-diazide-5-sulfonic acid ester of a bis-hydroxyphenylalkane, wherein the naphthoquinonediazidesulfonic acid ester corresponds to the general formula I

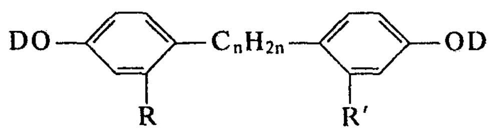

(I)

in which

| | |
|---|---|
| D | is the 1,2-naphthoquinone-2-diazide-5-sulfonyl radical or the 1,2-naphthquinone-2-diazide-4-sulfonyl radical, |
| R and R′ | are hydrogen atoms, alkyl groups having 1–4 carbon atoms or radicals of the formula DO, and |
| n | denotes a number from 6 to 18. |

2. A light-sensitive mixture as claimed in claim 1, which additionally contains a binder which is insoluble in water, but soluble or at least swellable in aqueous alkaline solutions.

3. A light-sensitive mixture as claimed in claim 1, which contains 3 to 50% by weight of a naphthoquinonediazidesulfonic acid ester, relative to its content of non-volatile constituents.

4. A light-sensitive mixture as claimed in claim 1, which contains a compound of the formula I in which at least one of the radicals R und R′ is a DO radical.

5. A light-sensitive mixture as claimed in claim 1, which contains a compound of the formula I in which n is a number from 8 to 14.

6. A light-sensitive copying material composed of a layer support and a light-sensitive layer containing a 1,2-naphthoquinone-2-diazidesulfonic acid ester of a bis-hydroxyphenylalkane, wherein the naphthoquinonediazidesulfonic acid ester corresponds to the general formula I

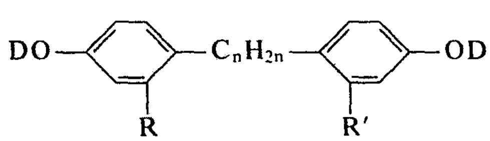

(I)

in which

| | |
|---|---|
| D | is the 1,2-naphthoquinone-2-diazide-5-sulfonyl radical or the 1,2-naphthoquinone-2-diazide-4-sulfonyl radical, |
| R and R′ | are hydrogen atoms, alkyl groups having 1–4 carbon atoms or radicals of the formula DO, and |
| n | denotes a number from 6 to 18. |

7. A light-sensitive copying material as claimed in claim 6, wherein the layer support is composed of aluminium.

**Revendications**

1. Mélange sensible à la lumière, qui contient comme composé sensilble à la lumière un ester de l'acide naphtoquinone-(1,2)-diazide-(2)-4- ou -5-sulfonique d'un bis-hydroxyphényl-alcane, caractérisé en ce que l'ester de l'acide naphtoquinonediazide sulfonique répond à la formule générale I

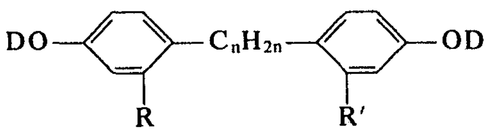

(I)

dans laquelle

D est le groupe naphtoquinone-(1,2)-diazide-(2)-5-sulfonyle ou -4-sulfonyle,
R et R' représentent des atomes d'hydrogène, des groupes alcoyle ayant de 1 à 4 atomes de carbone ou des groupes de formule DO et
n est un nombre de 6 à 18.

2. Mélange sensible à la lumière selon la revendication 1, caractérisé en ce qu'il contient en outre un liant insoluble dans l'eau, soluble ou pouvant au moins gonfler dans des solutions alcalines aqueuses.
3. Mélange sensible à la lumière selon la revendication 1, caractérisé en ce qu'il contient de 3 à 50% en poids d'ester de l'acide naphtoquinonediazide sulfonique, par rapport à sa teneur en constituants non-volatils.
4. Mélange sensible à la lumière selon la revendication 1, caractérisé en ce qu'il contient un composé de formule I dans lequel au moins un des groupes R et R' est un groupe DO.
5. Mélange sensible à la lumière selon la revendication 1, caractérisé en ce qu'il contient un composé de formule I dans lequel n est un nombre de 8 à 14.
6. Matériau de reproduction sensible à la lumière composé d'un support de couche et d'une couche sensible à la lumière, qui contient un ester de l'acide naphtoquinone-(1,2)-diazide-(2)-sulfonique d'un bis-hydroxyphényl-alcane, caractérisée en ce que l'ester de l'acide naphtoquinonediazide sulfonique correspond à la formule générale I

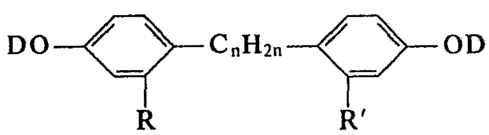

(I)

dans laquelle

D est le groupe naphtoquinone-(1,2)-diazide-(2)-5-sulfonyle ou -4-sulfonyle,
R et R' sont des atomes d'hydrogène, des groupes alcoyle ayant de 1 à 4 atomes de carbone ou des groupes de formule DO, et
n est un nombre de 6 à 18.

7. Matériau de reproduction sensible à la lumière selon la revendication 6, caractérisé en ce que le support de couche est en aluminium.